# EUROPEAN PATENT SPECIFICATION

(11) **EP 3 002 955 B1**
(45) Date of publication and mention of the grant of the patent: **24.05.2017**
(21) Application number: 15186449.3
(22) Date of filing: 23.09.2015
(51) Int. Cl.: H04Q 1/02

(54) **RACK MOUNTED EQUIPMENT POWER DISTRIBUTION SYSTEM ENHANCEMENTS**
GESTELLTRÄGERMONTIERTE AUSRÜSTUNG FÜR ENERGIEVERTEILUNGSSYSTEMVERBESSERUNGEN
AMÉLIORATIONS D'UN SYSTÈME DE DISTRIBUTION D'ÉNERGIE D'UN ÉQUIPEMENT MONTÉ EN BAIE

(30) Priority: 30.09.2014 US 201414501461
(43) Date of publication of application: 06.04.2016
(73) Proprietor: Schneider Electric IT Corporation, West Kingston, RI 02892 (US)
(72) Inventor: ROHR, Daniel J., Wildwood, MO 63011 (US); AYERS, Paul L., Melrose, MA 02176 (US); WATSON, Steven M., Manchester, MO 63021 (US); ALWAY, Malee, Wentzville, MO 63385 (US)
(74) Representative: Zerbi, Guido Maria

(56) References cited:
- US-A1- 2004 000 815
- US-A1- 2006 162 364
- US-A1- 2010 141 379
- US-A1- 2014 111 908
- US-B1- 7 591 383

## Description

### BACKGROUND

### 1. Technical Field

Aspects and embodiments of the present invention are directed generally to electronic equipment mounting racks, and more specifically, to power distribution units and sensors associated with electronic equipment mounting racks.

### 2. Discussion of Related Art

In response to the increasing demands of information-based economies, information technology networks continue to proliferate across the globe. One manifestation of this growth is the centralized network data center. A centralized network data center typically consists of various information technology equipment, collocated in a structure that provides network connectivity, electrical power, and cooling capacity. Often the equipment is housed in specialized enclosures termed "racks" which integrate these connectivity, power and cooling elements. The equipment racks may be provided in industry standard configurations, for example, as 19 inch (482.6 mm) or 23 inch (584.2 mm) wide racks. The equipment racks may include equipment mounting apertures vertically spaced at industry standard increments, for example, at multiples of 1.752 inches (44.50 mm), referred to as one rack unit or 1U, to facilitate the mounting of equipment having industry standardized dimensions, for example, a multiple of 1U minus about 1/32 inch (0.031 inches or 0.787 mm) high. In some instances, rails may be mounted to the mounting apertures and electronic equipment mounted on the rails. Equipment racks may be housed in rack cabinets which may include air passageways to direct the flow of air across the equipment in a rack. An industry standard rack cabinet is 42U high.

Equipment racks may include power distribution and wire management systems coupled to the racks to supply power and communication lines to the equipment in the racks. A type of power distribution system often used in electronic equipment racks, referred to as a "Rack Power Distribution Unit" or "rPDU" includes multiple electrical outlets for supplying power to equipment in a rack. One or more rPDUs may be mounted on one or both sides of the rear of a rack.

A similar rack power distribution unit is disclosed by the document US2004/000815, Hewlett Packard Development, published on 1 January 2004. Another document disclosing an equipments rack is the US2010/141379, Commscope, published on 10 June 2010.

### SUMMARY

In accordance with an aspect of the present disclosure, there is provided a rack power distribution unit (rPDU) and a method according to the appended claims.

### BRIEF DESCRIPTION OF DRAWINGS

The accompanying drawings are not intended to be drawn to scale. In the drawings, each identical or nearly identical component that is illustrated in various figures is represented by a like numeral. For purposes of clarity, not every component may be labeled in every drawing. In the drawings:
FIG. 1 is an elevational view of an embodiment of an electronic equipment rack;
FIG. 2A is an elevational view of an embodiment of a rack power distribution unit (rPDU);
FIG. 2B is a photograph of two rPDUs mounted in a front and rear configuration on an internal rear side wall of an electronic equipment rack;
FIG. 2C is a photograph of electrical power lines running from rPDUs mounted on opposite internal rear side wall of an electronic equipment rack to electronic equipment mounted in the electronic equipment rack;
FIG. 3A is an isometric view of an end of a rPDU including a display in a first position;
FIG. 3B is an isometric view of an end of a rPDU including a display in a second position;
FIG. 3C is a photograph of light emitting elements in a body of a display of a rPDU in the orientation illustrated in FIG. 3B illuminating electronic equipment mounted in an electronic equipment rack with the rPDU;
FIG. 3D is an isometric view of an end of a rPDU including a display in a third position;
FIG. 4 is a block diagram of an embodiment of control logic for light emitting elements in a display of a rPDU;
FIG. 5 is a schematic diagram of circuitry in an embodiment of a rack sensor system;
FIG. 6 is a block diagram of multiple rPDUs mounted in different positions in a rack;
FIG. 7 is an embodiment of control logic for determining a position of a rPDU in a rack;
FIG. 8 is a block diagram of a computer system included in some embodiments disclosed herein; and
FIG. 9 is a block diagram of a memory system of the computer system of FIG. 8.

### DETAILED DESCRIPTION

Aspects and embodiments disclosed herein are not limited to the details of construction and the arrangement of components set forth in the following description or illustrated in the drawings. The disclosed aspects and embodiments are capable of being practiced or of being carried out in various ways. Also, the phraseology and terminology used herein is for the purpose of description and should not be regarded as limiting. The use of "including," "comprising," "having," "containing," "involving," and variations thereof herein is meant to encompass the items listed thereafter and equivalents thereof as well as additional items.

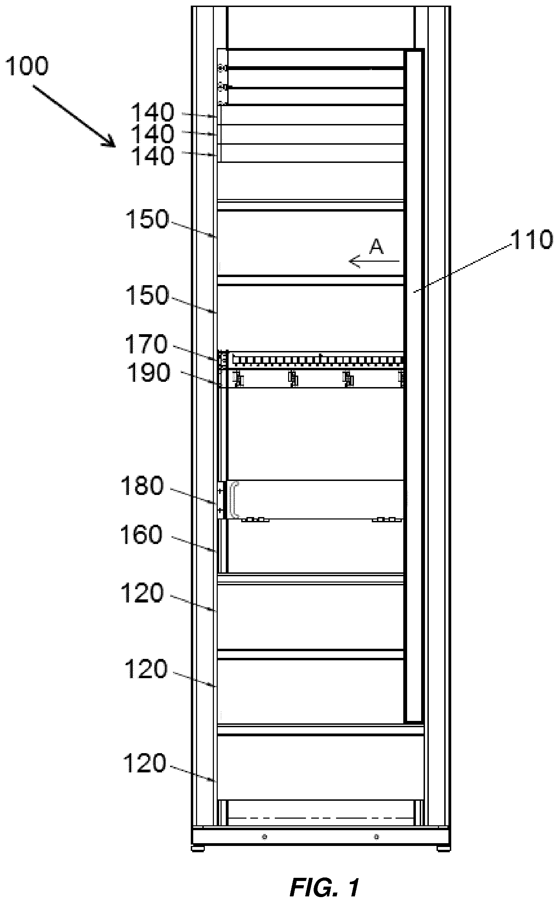

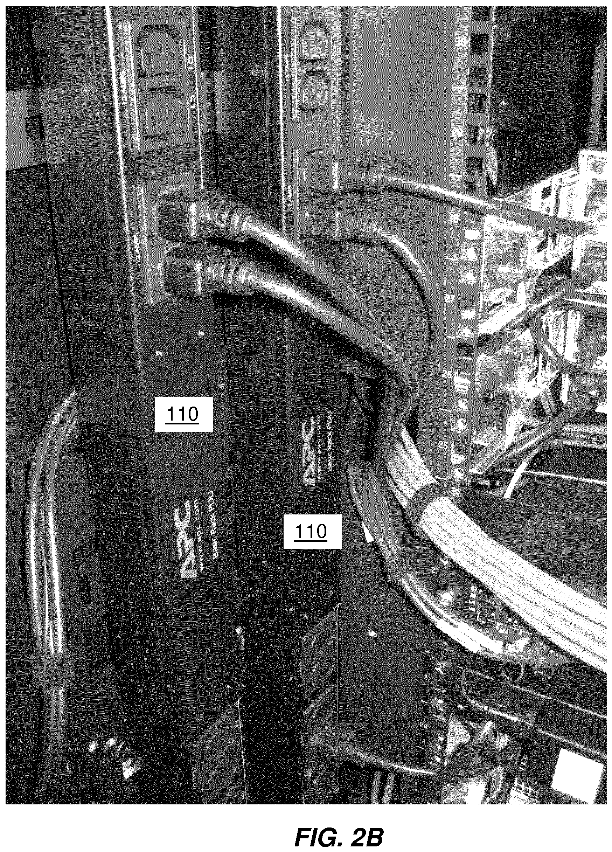

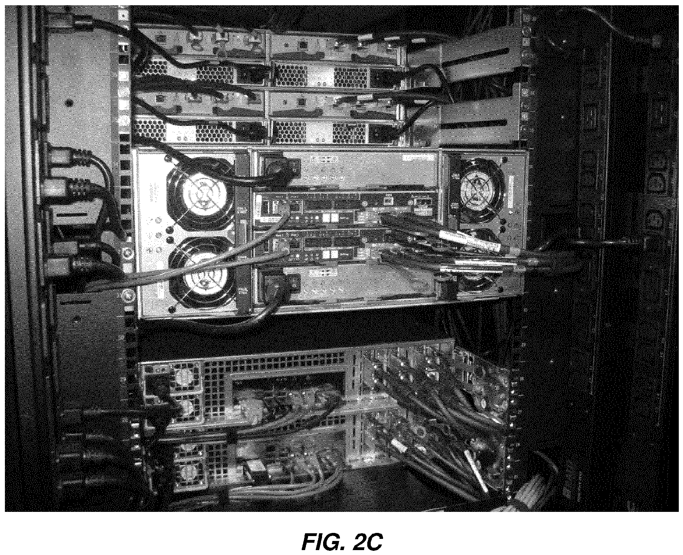

A simplified rear view of an electronic equipment rack (also referred to herein simply as a "rack") in accordance with various aspects and embodiments disclosed herein is illustrated in FIG. 1, generally at 100. The doors of the rack 100 are omitted from FIG. 1 for clarity. The rack may include drawer enclosures 120 including items that support power and/or network connections for other equipment mounted in the rack. Uninterruptible power supplies (UPSs) 140 may be installed as rack mounted devices to increase the power supply redundancy of the rack. The rack 100 may include computing or network technology equipment, for example, one or more data storage devices 150, servers 160, a patch panel 170, a keyboard tray 180, a cable organizer 190, and/or a monitor 195 or other user interface which may provide for an operator to communicate with the equipment in the rack. One or more rPDUs 110 may be mounted internal to the rack 100. The rPDU(s) 110 may be vertically mounted, as illustrated in FIG. 1, or may be horizontally mounted in the rack along with the other equipment in the rack. In some embodiments, at least one rPDU 110 is vertically mounted on each internal side of the rack 100. The rPDU(s) 110 may receive power from the UPSs 140 in the rack and may include power outlets to which power cords from the various other equipment in the rack may be electrically connected (See FIGS. 2B and 2C). The power outlets may face inward toward the center of the rack, in the direction indicated by arrow "A" in FIG. 1, or in other embodiments may face in other directions, for example, toward the rear or the front of the rack.

Previously known rPDUs include limited functionality. Some previously known rPDUs function simply as a power strip, similar to a power strip that a consumer may purchase from a retail electronics store and use for connecting multiple electronic devices to a single mains power outlet. rPDUs in accordance with various aspects and embodiments disclosed herein provide functionality beyond that which is offered in previously known rPDUs and may interact with various sensors and actuators associated with a rack on which the rPDUs are mounted to provide an integrated rack/rPDU solution.

In accordance with some aspects and embodiments, a rPDU may include lighting elements which may be configured to illuminate internal and/or external portions of a rack in which the rPDU is mounted and/or which may operate as indicators regarding various conditions associated with the rack and/or equipment mounted therein. The lighting elements may be mounted on the rPDU in a manner that provides for light emitted from the lighting elements to be directed in various directions as desired by an operator.

In accordance with some aspects and embodiments, a rPDU may include a monitor which may provide information to an operator regarding the status of the rPDU, the rack the rPDU is mounted in, and/or equipment mounted in the rack. In some embodiments, the display is configured to be tilted or repositioned into a position which facilitates ease of reading for an operator.

Various sensors may be integrated into a rack in which embodiments of a rPDU is mounted. The various sensors may communicate with the rPDU to provide the rPDU with information regarding the status of various portions of the rack and/or equipment mounted therein.

In some embodiments, a rPDU is provided with functionality for facilitating installation and ongoing status of the rPDU in a correct location and orientation in a rack. This functionality may help reduce the time required to mount a rPDU in a rack and commission the rPDU, and may reduce a number of errors associated with mounting a rPDU in a rack.

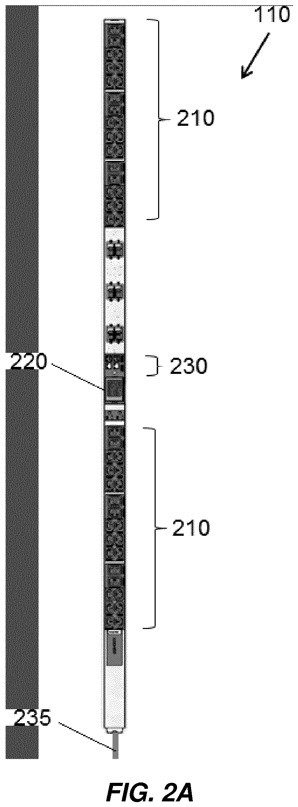

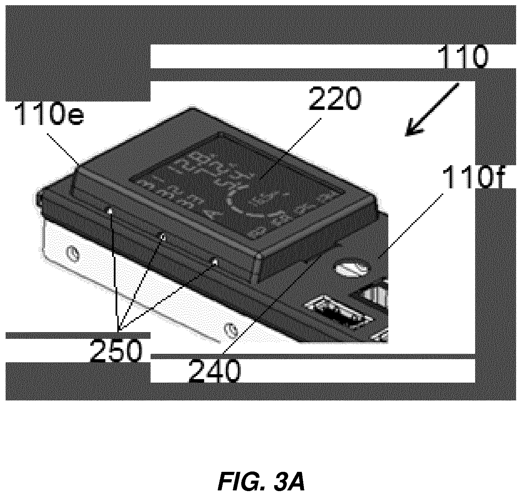

In accordance with one embodiment, a rPDU 110, as illustrated in FIG. 2A, includes one or more banks of power outlets 210, a display 220, and one or more input/output ports 230 (for example, USB ports, network and sensor ports, optical communication ports, or other forms of communication ports known in the art) configured to receive or transmit signals from various of the subsystems disclosed herein and/or to an external or remote computing system or database. The rPDU 110 may include a power inlet cord 235 (only an end of which is illustrated in FIG. 2A). The power inlet cord may extend from one end of the rPDU 110 as illustrated. The display may be located centrally in the rPDU 110 as shown in FIG. 2A or proximate an end 110e of the rPDU 110 as illustrated in FIGS. 3A-3C. In some embodiments, the display 220 is oriented facing outward from the front surface 110f of the rPDU 110 along with the power outlets in the banks of power outlets 210. In some embodiments, as illustrated in FIGS. 3A-3C, the display 220 is mounted on a pivot 240, axle, gimbal, or other tilting mechanism which provides for the display to be tilted into different orientations on-the-fly, for example, into orientations in which a plane defined by a surface of the display 220 is non-parallel with a plane defined by the front surface 110f of the rPDU 110. At least a portion of the body of the display 220 may be raised relative to the front surface 110f of the rPDU 110 so that the screen of the display 220 defines a plane different from a plane defined by the front surface 110f of the rPDU 110.

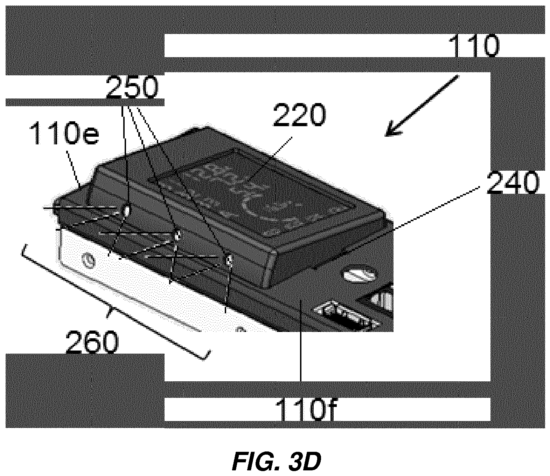

Light emitting elements 250, which may include, for example, white and/or colored light-emitting-diodes (LEDs) and/or other forms of light emitting elements, are disposed on either side of the body of the display 220 (light emitting elements 250 on only one side of the display 220 are visible in FIGS. 3A and 3D). Although three light emitting elements 250 are illustrated on a side of the display 220 in FIGS. 3A and 3D, in other embodiments, a single light emitting element 250, a pair of light emitting elements 250, or a plurality of more than three light emitting elements 250 may be utilized on one or both sides of the display 220. Additionally, one or more light emitting elements 250 may be positioned in other locations, for example, on a top and/or bottom surface and/or a front face of the display 220.

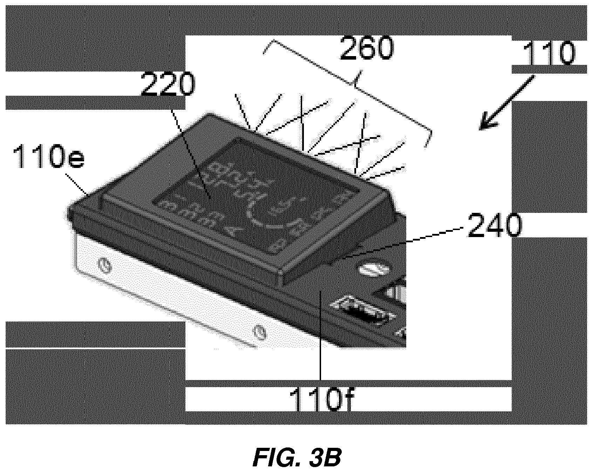

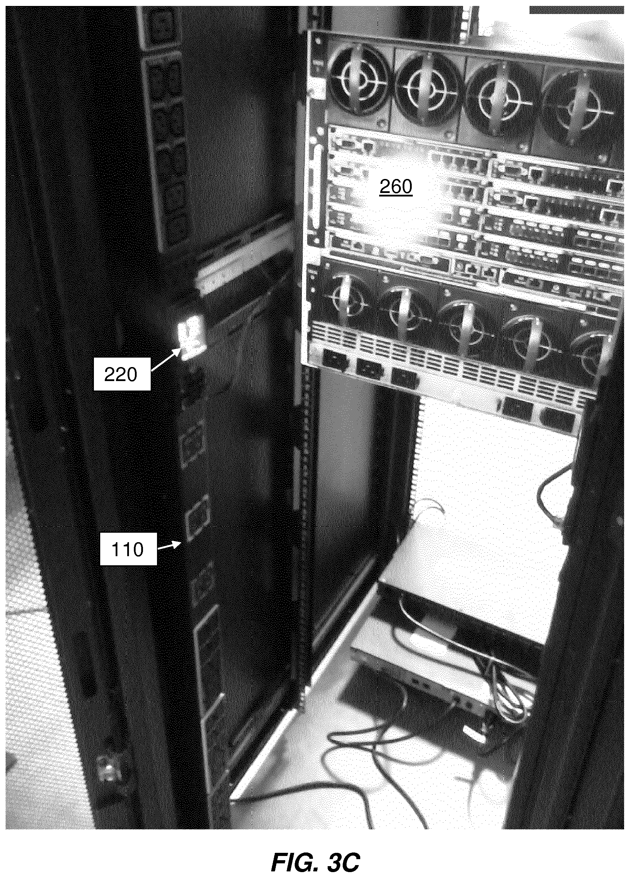

The body of the display 220 may be tilted about an axis of the pivot 240 to face in various directions as desired. For example, in FIG. 3B and FIG. 3C, if the rPDU 110 were vertically mounted to a left side of an internal rear surface of a rack 100 with the end 110e of the rPDU 110 being at the upper side of the mounted rPDU 110, the illustrated degree of tilt of the body of the display 220 would orient the screen of the display more toward an operator than if the body of the display 220 were parallel with the front surface 110f of the rPDU 110 as shown in FIG. 3A. Tilting of the body of the display 220 as illustrated in FIG. 3B and FIG. 3C would thus make the screen of the display easier to read by an operator standing behind the rack 100. Also, when the body of the display 220 is tiled as illustrated in FIG. 3B and FIG. 3C light emitting elements (not visible in FIG. 3B or FIG. 3C) located on the right side of the display 220 are elevated above the front surface 110f of the rPDU 110 and capable of emitting light 260 (represented by light rays 260) toward the inside of the rack 100, illuminating rear portions of equipment within the rack. In the orientation of the display 220 shown in FIG. 3B and FIG. 3C, the light emitting elements 250 on the left side of the display body are hidden beneath the front surface 110f of the rPDU 110.

Conversely, if the body of the display 220 is tilted about the pivot 240 as illustrated in FIG. 3D, with the screen of the display tilted away from an operator standing behind the rack, the light emitting elements 250 on the left side of the display are elevated above the front surface 110f of the rPDU 110 and capable of emitting light (represented by light rays 260) toward the rear of the rack 100. Emitting light toward the rear of the rack may assist an operator with performing work behind the rack, for example, reading a manual behind the rack, should the area behind the rack be otherwise insufficiently illuminated or illuminated to a lesser degree than desired. In the orientation of the display 220 shown in FIG. 3D, the light emitting elements 250 on the right side of the display body are hidden beneath the front surface 110f of the rPDU 110. In other embodiments, the rPDU 110 is configured to only emit light toward the inside of the rack and not outward from the rear of the rack. Position sensors in the rPDU 110, described further below, may provide for the rPDU 110 to determine which light emitting elements 250 face the inside of the equipment rack and may disable the other set of light emitting elements that face outward from the rear of the equipment rack.

In some embodiments, internal sensors, for example, capacitive sensors or potentiometers, may be included in the rPDU to provide an indication of the degree and/or direction of tilt of the body of the display 220. Data regarding the indication of the degree and/or direction of tilt of the body of the display 220 may be recorded in a database internal or remote from the rPDU. This data may be used to provide information regarding which rack(s) are most often accessed or serviced and may thus provide information useful for implementing or modifying a preventive maintenance program for a rack or racks.

In other embodiments, the body of the display 220 may rotate not just about a single axis, but may additionally or alternatively rotate about an axis perpendicular to that illustrated in FIGS. 3A-3D, for example, to rotate the upper and/or lower portions of the display toward or away from the body of the rPDU. In further embodiments, the body of the display 220 is configured to rotate about an axis normal to a plane defined by the front surface 110f of the rPDU 110 and/or a plane defined by the display 220. Such additional or alternative rotational axes may provide for the lighting from the light emitting elements to be more precisely aimed in a desired direction.

In some embodiments, the light emitting elements 250 may turn on and/or off automatically in response to different occurrences. For example, in some embodiments, the light emitting elements 250 turn on when the body of the display 220 is tilted away from an orientation parallel with the front surface 110f of the rPDU 110 and may turn off then the body of the display is in an orientation parallel with the front surface 110f of the rPDU 110. In other embodiments, the light emitting elements 250 turn on when a rear door of the rack is opened and turn off when the rear door of the rack is closed. In other embodiments, the light emitting elements 250 turn on responsive to the detection of an operator behind the rack with, for example, a motion detector or infrared detector facing behind the rack.

In some embodiments, the light emitting elements turn on and/or off gradually, for example, increasing in brightness from a full off state to a full on state, or vice versa, over a period of several seconds or some other predefined amount of time. Turning on and/or off the light emitting elements 250 over a period of time may reduce the chance of the light emitting elements startling an operator.

In other embodiments, the light emitting elements 250 may illuminate in response to a fault condition of the rPDU 110, the rack 100, and/or equipment mounted in the rack 100. In some embodiments, the light emitting elements 250 include colored elements, for example, red light emitting elements that illuminate in response to a fault condition. In other embodiments, the light emitting elements 250 flash or illuminate in different patterns responsive to different detected fault conditions. The pattern and/or color of illumination of the light emitting elements 250 may be modulated differently for different fault conditions so an operator could determine a type of fault condition from observation of the pattern and/or color of illumination of the light emitting elements 250. Non-limiting examples of fault conditions which the light emitting elements 250 may respond to include temperature outside a desired range at the front or rear of the rack, humidity proximate the rack being outside a desired range, a power failure to one or more power outlets of a rPDU or a UPS or ATS mounted in the rack, or air flow outside of a desired range through a portion or all of the rack. The illumination of the light emitting elements 250 may thus bring the attention of an operator to a rack which should be inspected or which may require maintenance. In other embodiments, the light emitting elements 250 on different rPDUs of different racks may be controlled from a remote location to provide an operator with an indication of a particular rack to direct the operator to that particular rack to perform a desired operation at the particular rack.

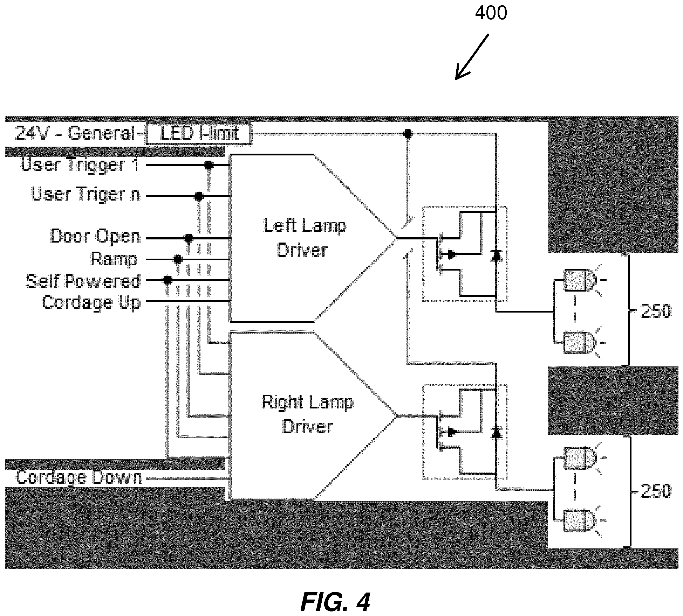

FIG. 4 is a schematic diagram of an embodiment of a control logic system 400 for controlling embodiments of the light emitting elements 250. An independent control/driver (Left Lamp Driver, Right Lamp Driver) is applied to each set of light emitting elements 250. In some embodiments, both sets of light emitting elements 250 are never on at the same time, so a common current source is shared. The control logic is driven by one or more user defined triggers (User Trigger 1 - User Trigger n), for example, temperatures sensors, humidity sensors, air flow sensors, equipment fault sensors, manual switches for powering on or off one or both sets of light emitting elements, etc., as well as door open sensors and/or sensors configured to determine whether the rack at large is powered by its own cordage (as opposed to sourcing power from a rPDU from another rack when its own power feed drops) connected to, for example the illustrated "Self Powered" input. A ramping behavior ("Ramp" input) can be applied to lessen the shock to an operator's eyes or to reduce the tendency of the light emitting elements to startle an operator. The "Cordage Up" and "Cordage Down" inputs provide information regarding the vertical orientation of the rPDU (a rPDU power cord generally is located on a single end of the rPDU) and thus information regarding whether the display 220 is facing right or facing left and which light emitting elements 250 of the rPDU are oriented toward the inside of the rack and which light emitting elements 250 of the rPDU are oriented toward the outside of the rack. The "Cordage Up" and "Cordage Down" inputs may be derived from a position sensor, for example, an accelerometer in the rPDU 110 as described in further detail below. It should be appreciated that any of the inputs illustrated in FIG. 4 may be fed to the rPDU directly from various sensor systems associated with the rack and/or rPDU or from software controls, which in turn are fed information from sensors of the various sensor systems.

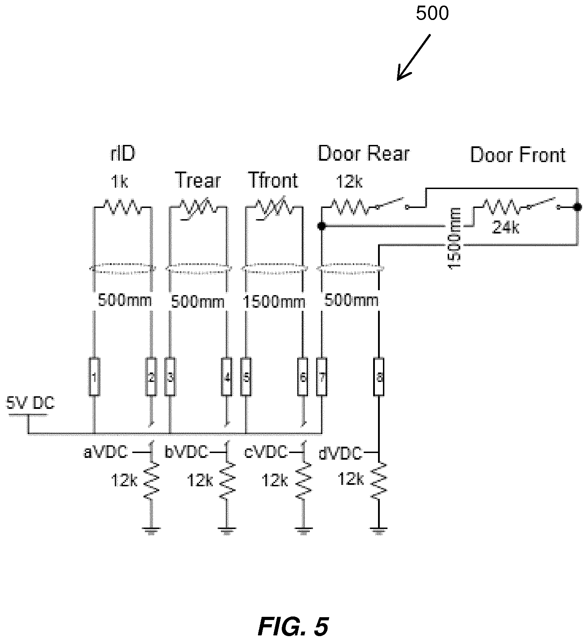

FIG. 5 is a schematic diagram of a sensor system 500 utilized in embodiments of a rack and rPDU system disclosed herein. The parameters of the disclosed sensor system, for example, the illustrated resistance values, voltages, and length and number of cables and sensor elements are illustrated as examples, and embodiments of the present disclosure are not limited to any particular values of these parameters. The sensor system 500 includes a bias voltage supply, for example, 5 volts DC as illustrated in FIG. 5 and pull-down resistors each having resistance values of, for example, 12 kΩ, as illustrated. The external cable circuitry (above the pin numbers 1-8) includes a rack ID resistor (rID), two temperature sensors (Trear, Tfront) and two door sensors (Door Rear, Door Front). Examples of various cable lengths (in millimeters) of each circuit path are also illustrated. The rack ID resistor has a value that varies for different racks and/or different types of racks. In some embodiments, each rack in a facility is provided with a rack ID resistor having a different resistance so that the sensor system 500 and/or an external or remote system in communication with the sensor system 500 can identify what rack the sensor system 500 is associated with. In other embodiments, the resistance value of the rack ID resistor varies with a type of rack, for example, a model number of a rack and/or a configuration of a rack and/or a number and type of electronic components included in a rack. The resistance value of the rack ID resistor rID is illustrated in FIG. 5 as 1kΩ.

Trear and Tfront are sensor elements used to measure temperature at the rear and the front of rack, respectively. Trear and/or Tfront are, in some embodiments, thermistors, for example, negative temperature coefficient (NTC) thermistors or positive temperature coefficient (PTC) thermistors. Trear and/or Tfront are in some embodiments, 160-1103 type NTC thermistors. Other type of temperature sensors, for example, themcouples, bimetallic temperature sensors, or any other form of temperature sensor known in the art may be used for Trear and/or Tfront in addition to, or as an alternative to a thermistor.

"Door Rear" and "Door Front" are sensors which provide an indication of whether the rear or front door, respectively, of a rack is open or closed. The "Door Rear" and "Door Front" sensors each include a switch which changes state (from open to closed or from closed to open) upon the associated rack door being opened. The switches used in the "Door Rear" and "Door Front" sensors are, in some embodiments, mechanical switches which close upon closing the associated door. In other embodiments, the switches used in the "Door Rear" and "Door Front" sensors are magnetically activated switches which change state upon a body of the switch located on a rack door (or on the rack) coming into proximity and/or contact with a magnet located on the rack (or rack door). Any switches known in the art which open or close responsive to the opening or closing of the rack doors may be used in the "Door Rear" and/or "Door Front" sensors.

The "Door Rear" and "Door Front" sensors also include resistors in series with the switches. The resistance values of the resistors in the "Door Rear" and "Door Front" sensors are in some embodiments different so that the state of both doors may be determined by reading a resistance value across a single pair of wires leading to the "Door Rear" and "Door Front" sensors. For example, with the "Door Front" sensor resistor having a resistance of 24kΩ and the "Door Rear" sensor resistor having a resistance of 12kΩ, a resistance measured across pins 7 and 8 in FIG. 5 would be infinite if both door switches were open, 24kΩ if the "Door Front" switch were closed and the "Door Rear" switch open, 12kΩ if the "Door Rear" switch were closed and the "Door Front" switch open, and 8kΩ (1/(1/12kΩ +1/24kΩ)) if both door switches were closed.

Racks not including a rear door would not include the "Door Rear" sensor. Racks not including a front door would not include the "Door Front" sensor.

In some embodiments, a supporting input port, for example, a RJ45 port is allocated for sensor system 500 in a rPDU 110 associated with the same rack as the sensor system 500. The supporting input port may be, for example, one of the ports 230 illustrated in FIG. 2A. The sensor system 500 mates to the input port and includes a single 8-wire cable routed out to a junction location within the sensor system assembly. From there, the various sensor nodes will fan out to their target locations within the rack. During installation (or upgrading) of the equipment rack and/or rPDU a technician may position the various sensors (rID, Trear, Tfront, Door Rear, Door Front, etc.) in the desired locations within the rack.

The resistance values across each of the sensor loops illustrated in FIG. 5 are detectable at aVDC, bVDC, cVDC and dVDC, using the formula xVDC = (5VDC x 12K) / (12K + the cable resistor). For example, for a rack having a rID resistor with a resistance of 1kΩ and a 12kΩ pull down resistor as illustrated in FIG. 5, 4.615V is detected at aVDC. Similarly, the state of the doors may be determined by a voltage read at dVDC. For example, if the front door is closed, causing the front door switch to close, and the rear door and rear door switch are open, 1.667V would be detected at dVDC.

The voltages at aVDC, bVDC, cVDC and dVDC may be monitored by the rPDU 110 or by an external or remote system in communication with the rPDU and/or sensor system 500 to control various actions with regard to the racks in a facility. For example, the voltage at aVCD provides information regarding the value of rID, and thus information regarding the type of rack and/or equipment contained in the rack. This information may be useful when deciding when to power up or power down different racks in response to changes in system load. Knowing if a rack door is open and/or which rack door is open facilitates proper control of lighting and alarms. The voltage readings at bVDC and/or cVDC provide information regarding the temperature of the rack which may be used to adjust ventilation of the rack as needed or to initiate an alarm if the measured temperature is outside of a desired range. In some embodiments, the rPDU 110 itself may issue commands responsive to the receipt of signals from the sensor system 500 to, for example, turn on or off one or more lights in a server room including the rack the rPDU is mounted in, or to adjust parameters of a cooling system associated with the rack the rPDU is mounted in.

It should be appreciated that additional sensors, for example, humidity sensors and/or air flow sensors may also be integrated into sensor system 500. Values of parameters measured by these additional sensors may be measured by reading a voltage or a current value on additional output terminals or pins of the sensor system 500.

In some embodiments, a rPDU is provided with position and/or orientation sensors which facilitate the installation of the rPDU in a rack in a proper location and orientation. In some rack systems, rPDUs are mounted on both left and right sides of the racks and multiple rPDUs may be mounted on each side of the rack, vertically and/or horizontally displaced from one another. It is desirable to mount specific rPDUs providing power to particular equipment in a rack in planned locations to facilitate identification of a rPDU powering a particular piece of equipment for maintenance or troubleshooting or repair purposes. In one embodiment, a rack includes two rPDUs on each side of the rack, a first of the rPDUs on each side of the rack positioned in front of a second of the rPDUs on each side of the rack. The rPDUs include sensors to determine which of the four positions in the rack a particular rPDU is located in.

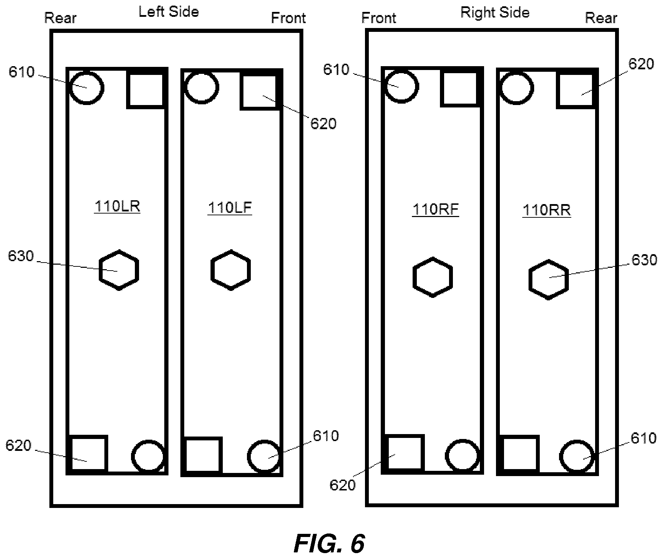

For example, as illustrated in FIG. 6, each rPDU 110 may include a pair of field or signal emitters 610 and a pair of detectors 620 which are configured to detect a field or signal emanating from the field or signal emitters 610. In one embodiment, the field or signal emitters 610 and detector 620 include magnets and reed switches. Hall sensors or other sensors capable of detecting magnetic fields may be used in addition to or as an alternative to the reed switches. In other embodiments, the field or signal emitters 610 and detector 620 may include, for example, photodiodes and photodetectors, rF emitters and detectors, or any other pair of complimentary field or signal emitters and detector known in the art. In some embodiments, the field or signal emitters 610 and detector 620 may be augmented with or replaced by, for example, pins and mechanical switches which are closed (or opened) by the pins when the rPDUs are appropriately mounted.

Each rPDU also includes an accelerometer 630, for example, a three-axis accelerometer. The accelerometer may be utilized to determine an orientation of the rPDU.

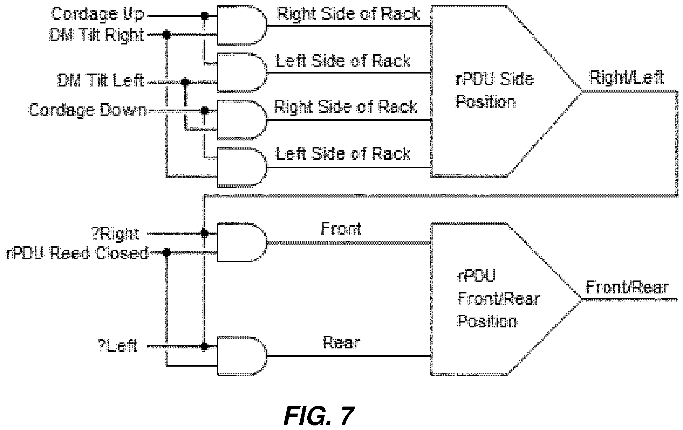

In FIG. 6 rPDU 110LR is in the left rear position in the rack, rPDU 110LF is in the left front position in the rack, rPDU 110RR is in the right rear position in the rack, and rPDU 110RF is in the right front position in the rack. These positions may be determined or verified with the field or signal emitters 610, detectors 620, and accelerometers 630, in conjunction with sensors detecting the tilt of the display 220 in accordance with the control logic shown in FIG. 7.

A technician installing a rPDU would tilt the display 220 of the rPDU in a direction such that the display 220 is facing in a rearward direction relative to an non-tilted orientation of the display 220. The accelerometer 630 provides information regarding the vertical orientation of the rPDU, which provides indication of a side of the rPDU (upper or lower) to which the power cord of the rPDU is attached. If the accelerometer 630 indicates that the power cord is in the upper end of the rPDU ("Cordage Up" input = "Yes") and the display 220 is tilted to the right ("DM Tilt Right" input = "Yes") the control logic would determine that the rPDU was on the right side of the rack. If the accelerometer 630 indicates that the power cord is in the upper end of the rPDU ("Cordage Up" input = "Yes") and the display 220 is tilted to the left ("DM Tilt Left" input = "Yes") the control logic would determine that the rPDU was on the left side of the rack. If the accelerometer 630 indicates that the power cord is in the lower end of the rPDU ("Cordage Down" input = "Yes") and the display 220 is tilted to the right ("DM Tilt Right" input = "Yes") the control logic would determine that the rPDU was on the left side of the rack. If the accelerometer 630 indicates that the power cord is in the lower end of the rPDU ("Cordage Down" input = "Yes") and the display 220 is tilted to the left ("DM Tilt Left" input = "Yes") the control logic would determine that the rPDU was on the left right of the rack. The "rPDU Side Position" decision block outputs the determined side of the rack on which the rPDU is located to the lower portion of the control logic diagram to determine if the rPDU is located in the front or rear position. If the rPDU was determined to be on the right side of the rack and the detector 620 indicated that it was sensing or receiving a signal from an adjacent field or signal emitter 610 ("rPDU Reed Closed" input = "Yes") the control logic would determine that the rPDU was in the front position. If the rPDU was determined to be on the left side of the rack and the detector 620 indicated that it was sensing or receiving a signal from an adjacent field or signal emitter 610 ("rPDU Reed Closed" input = "Yes") the control logic would determine that the rPDU was in the rear position.

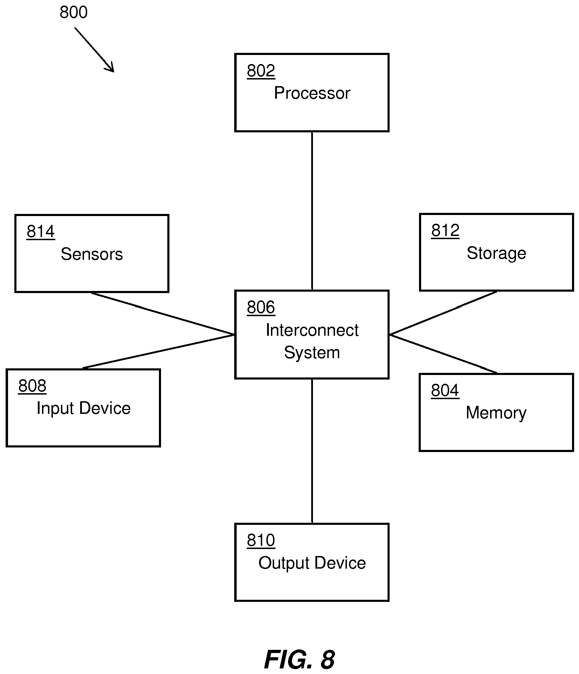

In some embodiments, an internal and/or an external controller for an rPDU 110 may include a computerized control system. Various aspects may be implemented as specialized software executing in a general-purpose or specialized computer system 800 such as that shown in FIG. 8. The computer system 800 may include a processor 802 connected to one or more memory devices 804, such as a disk drive, solid state memory, or other device for storing data. Memory 804 is typically used for storing programs and data during operation of the computer system 800.

Components of computer system 800 may be coupled by an interconnection mechanism 806, which may include one or more busses (e.g., between components that are integrated within a same machine) and/or a network (e.g., between components that reside on separate discrete machines). The interconnection mechanism 806 enables communications (e.g., data, instructions) to be exchanged between system components of system 800. Computer system 800 includes one or more input devices 808, for example, buttons 120, 130, a keyboard, mouse, trackball, microphone, or display 115 (which may include a touch screen) through which an operator may issue commands or programming to the system 800. Computer system 800 includes one or more output devices 810, for example, a printing device, a display (for example, display 220), and/or a speaker. One or more sensors 814 may also provide input to the computer system 800. These sensors may include, for example, door position sensors, rPDU position sensors 610, 620, 630, display tilt sensors, and/or one or more environmental sensors capable of providing information regarding parameters such as temperature, humidity, or air flow to the computer system 800. In addition, computer system 800 may contain one or more interfaces that connect computer system 800 to a communication network in addition or as an alternative to the interconnection mechanism 806.

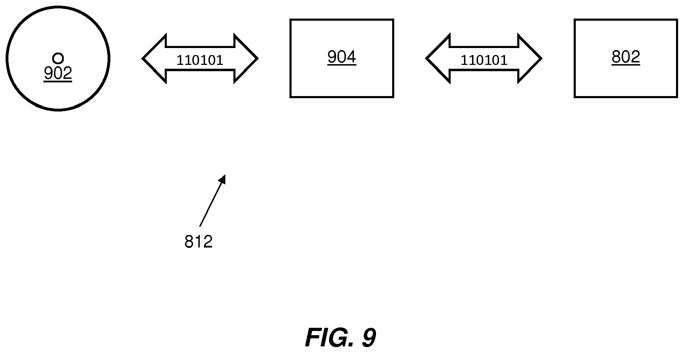

The storage system 812, shown in greater detail in FIG. 9, typically includes a computer readable and writeable nonvolatile recording medium 902 in which signals are stored that define a program to be executed by the processor or information to be processed by the program. The medium may include, for example, a disk or flash memory. Typically, in operation, the processor causes data to be read from the nonvolatile recording medium 902 into another memory 904 that allows for faster access to the information by the processor than does the medium 902. This memory 904 is typically a volatile, random access memory such as a dynamic random access memory (DRAM) or static memory (SRAM). It may be located in storage system 812, as shown, or in memory system 804. The processor 802 generally manipulates the data within the integrated circuit memory 804, 904 and then copies the data to the medium 902 after processing is completed. A variety of mechanisms are known for managing data movement between the medium 902 and the integrated circuit memory element 804, 904, and embodiments disclosed herein are not limited to any particular data movement mechanism. Embodiments disclosed herein are not limited to a particular memory system 804 or storage system 812.

The computer system may include specially-programmed, special-purpose hardware, for example, an application-specific integrated circuit (ASIC). Embodiments disclosed herein may be implemented in software, hardware or firmware, or any combination thereof. Further, such methods, acts, systems, system elements and components thereof may be implemented as part of the computer system described above or as an independent component.

Although computer system 800 is shown by way of example as one type of computer system upon which various embodiments disclosed herein may be practiced, it should be appreciated that the embodiments disclosed herein are not limited to being implemented on the computer system as shown in FIG. 8. Various embodiments disclosed herein may be practiced on one or more computers having a different architecture or components that that shown in FIG. 8.

Computer system 800 may be a general-purpose computer system that is programmable using a high-level computer programming language. Computer system 800 may be also implemented using specially programmed, special purpose hardware. In computer system 800, processor 802 is typically a commercially available processor such as the well-known Pentium™ or Core™ class processors available from the Intel Corporation. Many other processors are available. Such a processor usually executes an operating system which may be, for example, the Windows 7 or Windows 8 operating system available from the Microsoft Corporation, the MAC OS System X available from Apple Computer, the Solaris Operating System available from Sun Microsystems, or UNIX available from various sources. Many other operating systems may be used.

The processor and operating system together define a computer platform for which application programs in high-level programming languages are written. It should be understood that embodiments disclosed herein are not limited to a particular computer system platform, processor, operating system, or network. Also, it should be apparent to those skilled in the art that the embodiments disclosed herein are not limited to a specific programming language or computer system. Further, it should be appreciated that other appropriate programming languages and other appropriate computer systems could also be used.

One or more portions of the computer system may be distributed across one or more computer systems (not shown) coupled to a communications network. These computer systems also may be general-purpose computer systems. For example, various embodiments disclosed herein may be distributed among one or more computer systems configured to provide a service (e.g., servers) to one or more client computers, or to perform an overall task as part of a distributed system. For example, various embodiments disclosed herein may be performed on a client-server system that includes components distributed among one or more server systems that perform various functions according to various embodiments. These components may be executable, intermediate (e.g., IL) or interpreted (e.g., Java) code which communicate over a communication network (e.g., the Internet) using a communication protocol (e.g., TCP/IP). In some embodiments one or more components of the computer system 600 may communicate with one or more other components over a wireless network, including, for example, a cellular telephone network.

It should be appreciated that embodiments disclosed herein are not limited to executing on any particular system or group of systems. Also, it should be appreciated that embodiments disclosed herein are not limited to any particular distributed architecture, network, or communication protocol. Various embodiments may be programmed using an object-oriented programming language, such as SmallTalk, Java, C++, Ada, or C# (C-Sharp). Other object-oriented programming languages may also be used. Alternatively, functional, scripting, and/or logical programming languages may be used. Various embodiments disclosed herein may be implemented in a non-programmed environment (e.g., documents created in HTML, XML or other format that, when viewed in a window of a browser program, render aspects of a graphical-user interface (GUI) or perform other functions). Various embodiments disclosed herein may be implemented as programmed or non-programmed elements, or any combination thereof.

Having thus described several aspects of at least one embodiment of this invention, it is to be appreciated various alterations, modifications, and improvements will readily occur to those skilled in the art. The invention is defined by the appended claims.

## Claims

1. A rack power distribution unit - rPDU - (100) comprising:
a rPDU body (110) including a front surface;
a power inlet cord (235) coupled to the rPDU body (110);
a plurality of power outlets (210) on a surface of the rPDU body (110) in electrical communication with the power inlet cord; **characterised by**
a display (220) including a display body having a right side and a left side and a display screen, the display body pivotably mounted to the front surface of the rPDU body (110) and configured to pivot about an axis; and
a light emitting element (250) on the right side of the display body and a light emitting element (250) on the left side of the display body, the rPDU (110) being configured such that tilting of the display body about the axis exposes a first of the light emitting elements (250) above the front surface (110f) of the rPDU and hides a second of the light emitting elements (250) beneath the front surface (110f) of the rPDU (110).

2. The rPDU of claim 1, wherein the display body includes a portion extending in front of a plane defined by the front surface (110f) of the rPDU body.

3. The rPDU of claim 1, wherein the rPDU is configured to activate the light emitting element (250) responsive to tilting of the display body about the axis.

4. The rPDU of claim 2, wherein the rPDU is configured such that illumination from the light emitting element (250) illuminates an area external to the rPDU.

5. The rPDU of any of claims 2-4, mounted internal to an electronics equipment rack, the electronics equipment rack comprising a sensor system (500) including a plurality of sensors configured to provide an indication of status of parameters associated with the electronics equipment rack to the rPDU (110).

6. The rPDU of claim 5, configured to selectively illuminate an internal portion of the electronics equipment rack and an area behind the electronics equipment rack responsive to a direction and degree of tilt of the display (220) about a pivot axis (240).

7. The rPDU of claim 5, configured to activate one of the light emitting elements responsive to one of a fault condition of the rPDU, a fault condition of a piece of electronic equipment mounted in the electronics equipment rack, and an environmental parameter proximate the electronics equipment rack being outside of a predetermined range.

8. The rPDU of claim 5, further comprising a plurality of position sensors configured to provide an indication of a position of the rPDU (110) within the electronics equipment rack, one or more of the plurality of position sensors configured to communicate with one or more position sensors on an adjacent rPDU in the electronics equipment rack.

9. A method of mounting a rPDU in an electronics equipment rack, the method comprising:
attaching the rPDU (110) to a portion of the electronics equipment rack; and
tilting a display (220) pivotably mounted to a front surface (110f) of a body of the rPDU toward a rear of the electronics equipment rack, tilting of the display body exposing a first light emitting element (250) on a first side of a body of the display above the front surface (110f) of the body of the rPDU (110) and hiding a second light emitting element on a second side of the body of the display beneath the front surface (110f) of the body of the rPDU (110).

10. The method of claim 9, further comprising electrically connecting the rPDU (110) to a sensor system (500) including a plurality of sensors configured to provide an indication of status of parameters associated with the electronics equipment rack to the rPDU (110).

11. The method of claim 10, further comprising reading a type of the electronics equipment rack from the sensor system (500) with the rPDU (110) and transmitting an indication of the type of the electronics equipment rack and a status of one or more sensors of the sensor system (500) to a remote computing device.

12. The method of claim 9, wherein tilting the display of the rPDU toward a rear of the electronics equipment rack causes one of the light emitting elements (250) disposed on the body of the display to move into a position facing an internal portion of the electronics equipment rack and to illuminate the internal portion of the electronics equipment rack.

13. The method of claim 9, further comprising verifying a correct position and orientation of the rPDU (110) within the electronics equipment rack utilizing one or more position sensors included in the rPDU (110).

## Patentansprüche

1. Eine Gestell-Stromverteilereinheit - rPDU - (100), die Folgendes beinhaltet:
einen rPDU-Körper (110), der eine vordere Oberfläche umfasst;
ein Stromeingangskabel (235), das mit dem rPDU-Körper (110) gekoppelt ist;
eine Vielzahl von Stromabgängen (210) auf einer Oberfläche des rPDU-Körpers (110) in elektrischer Verbindung mit dem Stromeingangskabel; **gekennzeichnet durch** eine Anzeige (220), die einen Anzeigenkörper mit einer rechten Seite und einer linken Seite und einem Bildschirm umfasst, wobei der Anzeigenkörper an der vorderen Oberfläche des rPDU-Körpers (110) schwenkbar montiert und konfiguriert ist, um um eine Achse zu schwenken; und
ein Licht emittierendes Element (250) auf der rechten Seite des Anzeigenkörpers und
ein Licht emittierendes Element (250) auf der linken Seite des Anzeigenkörpers, wobei die rPDU (110) so konfiguriert ist, dass ein Kippen des Anzeigenkörpers um die Achse ein erstes der Licht emittierenden Elemente (250) über der vorderen Oberfläche (110f) der rPDU freilegt und ein zweites der Licht emittierenden Elemente (250) unter der vorderen Oberfläche (110f) der rPDU (110) verbirgt.

2. rPDU gemäß Anspruch 1, wobei der Anzeigenkörper einen Abschnitt umfasst, der sich vor einer durch die vordere Oberfläche (110f) des rPDU-Körpers definierten Ebene erstreckt.

3. rPDU gemäß Anspruch 1, wobei die rPDU konfiguriert ist, um das Licht emittierende Element (250) als Reaktion auf das Kippen des Anzeigenkörpers um die Achse zu aktivieren.

4. rPDU gemäß Anspruch 2, wobei die rPDU so konfiguriert ist, dass die Beleuchtung von dem Licht emittierenden Element (250) einen Bereich außerhalb der rPDU beleuchtet.

5. rPDU gemäß einem der Ansprüche 2-4, die innerhalb eines Gestells für elektronische Ausrüstung montiert ist, wobei das Gestell für elektronische Ausrüstung ein Sensorsystem (500) beinhaltet, welches eine Vielzahl von Sensoren umfasst, die konfiguriert sind, um der rPDU (110) eine Angabe eines Status von mit dem Gestell für elektronische Ausrüstung assoziierten Parametern bereitzustellen.

6. rPDU gemäß Anspruch 5, die konfiguriert ist, um einen inneren Abschnitt des Gestells für elektronische Ausrüstung und einen Bereich hinter dem Gestell für elektronische Ausrüstung als Reaktion auf eine Richtung und einen Kippgrad der Anzeige (220) um eine Schwenkachse (240) selektiv zu beleuchten.

7. rPDU gemäß Anspruch 5, die konfiguriert ist, um eines der Licht emittierenden Elemente als Reaktion auf eines von einem Fehlerzustand der rPDU, einem Fehlerzustand eines in dem Gestell für elektronische Ausrüstungen montierten elektronischen Geräts und eines Umweltparameters nahe dem Gestell für elektronische Ausrüstungen, der außerhalb einer vorgegebenen Spanne liegt, zu aktivieren.

8. rPDU gemäß Anspruch 5, die ferner eine Vielzahl von Positionssensoren beinhaltet, welche konfiguriert sind, um eine Angabe einer Position der rPDU (110) innerhalb des Gestells für elektronische Ausrüstung bereitzustellen, wobei einer oder mehrere der Vielzahl von Positionssensoren konfiguriert sind, um mit einem oder mehreren Positionssensoren auf einer benachbarten rPDU in dem Gestell für elektronische Ausrüstung zu kommunizieren.

9. Ein Verfahren zum Montieren einer rPDU in einem Gestell für elektronische Ausrüstung, wobei das Verfahren Folgendes beinhaltet:
Anbringen der rPDU (110) an einem Abschnitt des Gestells für elektronische Ausrüstung; und
Kippen einer schwenkbar an einer vorderen Oberfläche (110f) eines Körpers der rPDU montierten Anzeige (220) in Richtung einer Rückseite des Gestells für elektronische Ausrüstung, wobei das Kippen des Anzeigenkörpers ein erstes Licht emittierendes Element (250) auf einer ersten Seite eines Körpers der Anzeige über der vorderen Oberfläche (110f) des Körpers der rPDU (110) freilegt und ein zweites Licht emittierendes Element auf einer zweiten Seite des Körpers der Anzeige unter der vorderen Oberfläche (110f) des Körpers der rPDU (110) verbirgt.

10. Verfahren gemäß Anspruch 9, das ferner das elektrische Verbinden der rPDU (110) mit einem Sensorsystem (500) beinhaltet, welches eine Vielzahl von Sensoren umfasst, die konfiguriert sind, um der rPDU (110) eine Angabe eines Status von mit dem Gestell für elektronische Ausrüstung assoziierten Parametern bereitzustellen.

11. Verfahren gemäß Anspruch 10, das ferner das Ablesen eines Typs des Gestells für elektronische Ausrüstung aus dem Sensorsystem (500) mit der rPDU (110) und das Übertragen einer Angabe des Typs des Gestells für elektronische Ausrüstung und eines Status eines oder mehrerer Sensoren des Sensorsystems (500) an eine entfernte Rechenvorrichtung beinhaltet.

12. Verfahren gemäß Anspruch 9, wobei das Kippen der Anzeige der rPDU in Richtung einer Rückseite des Gestells für elektronische Ausrüstung bewirkt, dass sich eines der auf dem Körper der Anzeige angeordneten Licht emittierenden Elemente (250) in eine Position bewegt, die einem inneren Abschnitt des Gestells für elektronische Ausrüstung zugewandt ist, und den inneren Abschnitt des Gestells für elektronische Ausrüstung beleuchtet.

13. Verfahren gemäß Anspruch 9, das ferner das Verifizieren einer korrekten Position und Ausrichtung der rPDU (110) innerhalb des Gestells für elektronische Ausrüstung unter Nutzung eines oder mehrerer in der rPDU (110) umfasster Positionssensoren beinhaltet.

## Revendications

1. Une unité de distribution d'alimentation de baie - rPDU - (100) comprenant :
un corps de rPDU (110) incluant une surface avant ;
un cordon d'entrée d'alimentation (235) couplé au corps de rPDU (110) ;
une pluralité de prises d'alimentation (210) sur une surface du corps de rPDU (110) en communication électrique avec le cordon d'entrée d'alimentation ; **caractérisée par** un affichage (220) incluant un corps d'affichage ayant un côté droit et un côté gauche et
un écran d'affichage, le corps d'affichage étant monté de façon pivotante sur la surface avant du corps de rPDU (110) et configuré pour pivoter sur un axe ; et
un élément électroluminescent (250) sur le côté droit du corps d'affichage et un élément électroluminescent (250) sur le côté gauche du corps d'affichage, la rPDU (110) étant configurée de telle sorte qu'une inclinaison du corps d'affichage sur l'axe expose un premier des éléments électroluminescents (250) au-dessus de la surface avant (110f) de la rPDU et cache un deuxième des éléments électroluminescents (250) au-dessous de la surface avant (110f) de la rPDU (110).

2. La rPDU de la revendication 1, où le corps d'affichage inclut une portion s'étendant devant un plan défini par la surface avant (110f) du corps de rPDU.

3. La rPDU de la revendication 1, où la rPDU est configurée pour activer l'élément électroluminescent (250) en réponse à une inclinaison du corps d'affichage sur l'axe.

4. La rPDU de la revendication 2, où la rPDU est configurée de telle sorte qu'un éclairage provenant de l'élément électroluminescent (250) éclaire une zone externe à la rPDU.

5. La rPDU de n'importe lesquelles des revendications 2 à 4, montée à l'intérieur d'une baie d'équipement électronique, la baie d'équipement électronique comprenant un système de capteurs (500) incluant une pluralité de capteurs configurés pour fournir une indication de statut de paramètres associés à la baie d'équipement électronique à la rPDU (110).

6. La rPDU de la revendication 5, configurée pour éclairer de manière sélective une portion interne de la baie d'équipement électronique et une zone derrière la baie d'équipement électronique en réponse à une direction et un degré d'inclinaison de l'affichage (220) sur un axe de pivotement (240).

7. La rPDU de la revendication 5, configurée pour activer un des éléments électroluminescents en réponse au fait qu'une condition parmi une condition de défaut de la rPDU, une condition de défaut d'une pièce d'un équipement électronique monté dans la baie d'équipement électronique, et un paramètre environnemental près de la baie d'équipement électronique est en dehors d'une gamme prédéterminée.

8. La rPDU de la revendication 5, comprenant en outre une pluralité de capteurs de position configurés pour fournir une indication d'une position de la rPDU (110) au sein de la baie d'équipement électronique, un ou plusieurs capteurs parmi la pluralité de capteurs de position étant configurés pour communiquer avec un ou plusieurs capteurs de position sur une rPDU adjacente dans la baie d'équipement électronique.

9. Un procédé de montage d'une rPDU dans une baie d'équipement électronique, le procédé comprenant :
attacher la rPDU (110) sur une portion de la baie d'équipement électronique ; et
incliner un affichage (220) monté de façon pivotante sur une surface avant (110f) d'un corps de la rPDU vers un arrière de la baie d'équipement électronique, l'inclinaison du corps d'affichage exposant un premier élément électroluminescent (250) sur un premier côté d'un corps de l'affichage au-dessus de la surface avant (110f) du corps de la rPDU (110) et cachant un deuxième élément électroluminescent sur un deuxième côté du corps de l'affichage au-dessous de la surface avant (110f) du corps de la rPDU (110).

10. Le procédé de la revendication 9, comprenant en outre la connexion électrique de la rPDU (110) à un système de capteurs (500) incluant une pluralité de capteurs configurés pour fournir une indication de statut de paramètres associés à la baie d'équipement électronique à la rPDU (110).

11. Le procédé de la revendication 10, comprenant en outre la lecture d'un type de la baie d'équipement électronique à partir du système de capteurs (500) avec la rPDU (110) et la transmission d'une indication du type de la baie d'équipement électronique et d'un statut d'un ou de plusieurs capteurs du système de capteurs (500) à un dispositif informatique à distance.

12. Le procédé de la revendication 9, où l'inclinaison de l'affichage de la rPDU vers un arrière de la baie d'équipement électronique amène un des éléments électroluminescents (250) disposés sur le corps de l'affichage à se déplacer dans une position faisant face à une portion interne de la baie d'équipement électronique et à éclairer la portion interne de la baie d'équipement électronique.

13. Le procédé de la revendication 9, comprenant en outre la vérification d'une position et d'une orientation correctes de la rPDU (110) au sein de la baie d'équipement électronique en utilisant un ou plusieurs capteurs de position inclus dans la rPDU (110).
